# EUROPEAN PATENT SPECIFICATION

(11) **EP 1 687 841 B1**
(45) Date of publication and mention of the grant of the patent: **01.12.2010**
(21) Application number: 04791649.9
(22) Date of filing: 28.10.2004
(51) Int. Cl.: H01L 21/20, C30B 25/04

(54) **FORMATION OF LATTICE-TUNING SEMICONDUCTOR SUBSTRATES**
HERSTELLUNG VON GITTERABSTIMMUNGS-HALBLEITERSUBSTRATEN
FORMATION DE SUBSTRATS SEMICONDUCTEURS ACCORDES AU RESEAU

(30) Priority: 12.11.2003 GB 0326321
(43) Date of publication of application: 09.08.2006
(73) Proprietor: AdvanceSis Limited, Coventry CV4 7EZ (GB)
(72) Inventor: CAPEWELL, Adam, Daniel, Warwickshire CV31 1LB (GB); PARKER, Evan, Hubert, Cresswell, Warwick CV34 4JZ (GB); GRASBY, Timothy, John, Solihull B91 2PJ (GB)
(74) Representative: Harding, Richard Patrick
(86) International application number: PCT/GB2004/050022
(87) International publication number: WO 2005/048330

(56) References cited:
- EP-A- 1 363 318
- EP-A- 1 367 150
- US-A1- 2003 139 037
- US-A1- 2003 183 827

## Description

This invention relates to the production of lattice-tuning semiconductor substrates, and is more particularly, but not exclusively, concerned with the production of relaxed SiGe (silicon/germanium) "virtual substrates" suitable for the growth of strained silicon or SiGe active layers and unstrained III-V semiconductor active layers within which active semiconductor devices, such as MOSFETs, may be fabricated.

It is known to epitaxially grow a strained Si layer on a Si wafer with a relaxed SiGe buffer layer interposed therebetween, and to fabricate semiconductor devices, such as MOSFETs, within the strained Si layer in order to enhance the properties of the semiconductor devices. The buffer layer is provided in order to increase the lattice spacing relative to the lattice spacing of the underlying Si substrate, and is generally called a virtual substrate.

It is also known to epitaxially grow an alloy of silicon and germanium (SiGe) on the silicon substrate to form the buffer layer. Since the lattice spacing of SiGe is greater than the normal lattice spacing of Si, the desired increase in lattice spacing is achieved by the provision of such a buffer layer if the buffer layer is allowed to relax.

The relaxation of the buffer layer inevitably involves the production of dislocations in the buffer layer to relieve the strain. These dislocations generally form a half loop from the underlying surface which expands to form a long dislocation at the strained interface. However the production of threading dislocations which extend through the depth of the buffer layer is detrimental to the quality of the substrate, in that such dislocations can produce an uneven surface and can cause scattering of electrons within the active semiconductor devices. Furthermore, since many dislocations are required to relieve the strain in a SiGe layer, such dislocations inevitably interact with one another causing pinning of threading dislocations. Additionally more dislocations are required for further relaxation, and this can result in a higher density of threading dislocations.

Known techniques for producing such a buffer layer, such as are disclosed in US5442205, US 5221413, WO 98/00857 and JP 6-252046, involve linearly grading the Ge composition in the layer in order that the strained interfaces are distributed over the graded region. This means that the dislocations that form are also distributed over the graded region and are therefore less likely to interact. However such techniques suffer from the fact that the main sources of dislocations are multiplication mechanisms in which many dislocations are generated from the same source, and this causes the dislocations to be clustered in groups, generally on the same atomic glide planes. The strain fields from these groups of dislocations can cause the virtual substrate surface to have large undulations which is both detrimental to the quality of the virtual substrate and has the added effect of trapping threading dislocations.

US 2002/0017642A1 describes a technique in which the buffer layer is formed from a plurality of laminated layers comprising alternating layers of a graded SiGe layer having a Ge composition ratio which gradually increases from the Ge composition ratio of the material on which it is formed to an increased level, and a uniform SiGe layer on top of the graded SiGe layer having a Ge composition ratio at the increased level which is substantially constant across the layer. The provision of such alternating graded and uniform SiGe layers providing stepped variation in the Ge composition ratio across the buffer layer makes it easier for dislocations to propagate in lateral directions at the interfaces, and consequently makes it less likely that threading dislocations will occur, thus tending to provide less surface roughness. However this technique requires the provision of relatively thick, carefully graded alternating layers in order to provide satisfactory performance, and even then can still suffer performance degradation due to the build-up of threading dislocations.

It is an object of the invention to provide a method of forming a lattice-tuning semiconductor substrate in which performance is enhanced by decreasing the density of threading dislocations as compared with known techniques.

According to the present invention there is provided a method of forming a lattice-tuning semiconductor substrate, comprising:
(a) defining a selected area (12) of a semiconductor surface (15) by means of a window (13) extending through an isolating layer (11) on the semiconductor surface (15);
(b) defining in the vicinity of the window (13) a depression (14) in the isolating layer (11);
(c) growing on top of the selected area (12) of the semiconductor surface (15) an active layer (16) of a semiconducting material that is not lattice-matched to the material of the semiconductor surface (15) such that dislocations (17) are formed in the window (13) to relieve the strain in the active layer (16); and
(d) further growing the active layer (16) to overgrow the isolating layer (11) and fill the depression (14) to form a dislocation-free area (18) of said semiconducting material within the depression (14).

Such a technique is capable of producing high quality virtual substrates, of SiGe for example, with extremely low levels of threading dislocations, that is with levels from less than 10⁶ dislocations per cm² to virtually no threading dislocations. This is as a result of the fact that the dislocations produced in the SiGe layer within the window prior to further growth of the SiGe layer serve to relieve the strain in the SiGe layer, so that, when the overgrowth of the SiGe layer occurs, the area of SiGe within the depression is produced substantially without dislocations. The resulting virtual substrate is of superior quality. The quality of the virtual substrate produced may be such as to render it suitable for specialised applications, for example in microelectronics or in full CMOS integration systems.

This technique has particular advantage in that the virtual substrate does not cover the whole of the wafer, but instead is only present in pre-defined areas. These areas may be as small as required, and may, for example, be the size of an electronic device so that the benefits of strained silicon can be employed without affecting the processing of the other devices on the wafer.

In a preferred embodiment of the invention the portion of the active layer that has overgrown the isolating layer is removed after the growing of the active layer to fill the depression, so as to isolate the dislocation-free area of said semiconducting material within the depression from the area of said semiconducting material within the window. Preferably the portion of the active layer that has overgrown the isolating layer is removed by polishing down to the level of the isolating layer. Once the surface has been polished flat a substantially dislocation-free virtual substrate is left, completely isolated from the substrate by the material of the isolating layer, which will usually be a Si oxide layer.

In a further development of the invention the active layer and the isolating layer are removed from the semiconductor surface after the growing of the active layer to fill the depression, except in the vicinity of the depression, so as to leave on the semiconductor surface the dislocation-free area of said semiconducting material isolated from the semiconductor surface by the portion of the isolating layer. Preferably the active layer and the isolating layer are removed from the semiconductor surface by etching. The virtual substrate left on the oxide would then be an ideal template for strained silicon devices which could be integrated with "normal" silicon devices on the semiconductor substrate. The virtual substrate need therefore only be fabricated underneath devices which need the performance enhancements of strained silicon. The oxide underneath the virtual substrate would usually be arranged to be thin in order that the surface is kept as planar as possible for device processing.

The active layer may be annealed at an elevated temperature in order to substantially fully relieve the strain in the active layer. Furthermore the growth of the active layer may be carried out at a temperature in the range from room temperature to 1200°C, and preferably in the range from 350 to 900°C, and the annealing of the active layer may be carried out at an elevated temperature in the range from room temperature to 1500°C, and preferably in the range from 500 to 1200°C.

The active layer may have a Ge composition ratio that is substantially constant within the active layer. Alternatively the active layer may comprise first and second sub-layers, one of the sub-layers having a Ge composition ratio that is substantially constant within the sub-layer, and the other sub-layer having a Ge composition ratio that increases within the layer from a first level to a second level greater than the first level. In this case intermediate processing may be conducted between the growth of the first and second sub-layers. The intermediate processing may incorporate a step of annealing the first sub-layer at an elevated temperature in order to substantially fully relieve the strain in the first sub-layer. Furthermore the intermediate processing step may incorporate a chemo-mechanical polishing step.

The active layer may be grown by a selective epitaxial growth process, such as chemical vapour deposition (CVD).

In order that the invention may be more fully understood, reference will now be made to the accompanying drawings, in which:

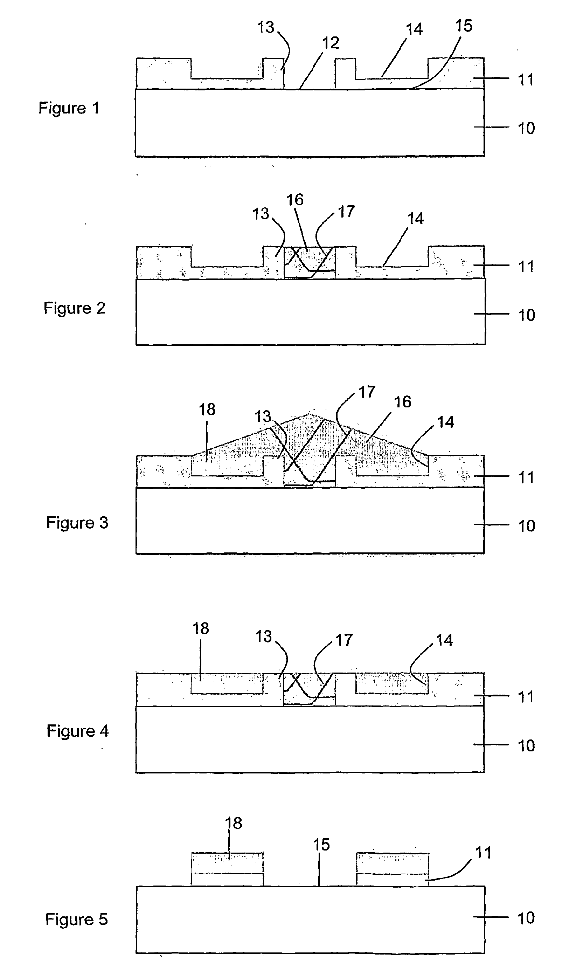

Figures 1 to 5 are explanatory cross-sectional views showing successive steps in the formation of a lattice-tuning semiconductor substrate in accordance with the invention.

The following description is directed to the formation of a virtual lattice-tuning Si substrate on an underlying Si substrate with the interposition of a SiGe buffer layer. However it should be appreciated that the invention is also applicable to the production of other types of lattice-tuning semiconductor substrates, including substrates terminating at fully relaxed pure Ge allowing III-V incorporation with silicon. It is also possible in accordance with the invention to incorporate one or more surfactants, such as antimony for example, in the epitaxial growth process in order to produce even smoother virtual substrate surfaces and lower density threading dislocations by reducing surface energy.

Referring to Figure 1, in the exemplary method in accordance with the invention for forming a relaxed SiGe virtual substrate suitable for growth of strained Si or SiGe active layers and unstrained III-V semiconductor active layers within which active semiconductor devices, such as MOSFETs, may be fabricated, an isolating layer 11 of Si oxide is grown on a Si substrate 10 and is then selectively etched after the area to be etched has been defined, for example by the application of a photoresist layer to the oxide layer and the selective exposure and development of the photoresist layer to form a photoresist mask. This etching step produces at least one window 13 extending all the way through the oxide to the Si surface 15 and at least one depression 14 extending only part of the way through the oxide so as to be separated from the Si surface 15 by an underlying portion of the oxide layer 11. The different etching depths of the windows 13 and depressions 14 are produced in known manner, for example by two separate masking and etching steps applied sequentially. For example, the isolating layer 11 could consist of a two separate isolating films on top of each other, such as a silicon nitride film on top of a silicon oxide film. To produce the depressions 14, a mask and photoresist could be used to expose the areas to be etched and selective etching of the upper isolating film could then be achieved using selective chemical etches or reactive ion etches, with the lower isolating film acting as an etch-stop. The window 13 could then be produced using a further mask and photoresist to expose the area to be etched, and using an etch to etch through both the upper isolating film and the lower isolating film.

Referring to Figure 2, in a subsequent selective CVD epitaxial growth process, a SiGe layer 16 is grown on the selected area 12 of the Si surface 15 defined by the window 13 through the oxide layer 11 at a temperature in the range from room temperature to 1200°C, and preferably in the range from 350 to 900°C. This is possible with the addition of HCI into the growth gases or chlorinated precursors (e.g. dichlorosilane) that produce HCI during growth such that the HCI effectively "etches" any polycrystalline growth that occurs on the oxide, whilst leaving the crystalline growth in the windows intact. This occurs because the weak bonding of the polysilicon layer to the oxide allows the HCI to easily etch any deposition, whereas the strong bonding of the silicon (or germanium) to the silicon of the substrate is impervious to the HCI. As this SiGe layer 16 is grown the strain is eventually relaxed by the formation of dislocations 17 within SiGe layer 16. These dislocations 17 generally extend from the boundaries between the SiGe layer 16 and the surrounding oxide layer 11 to the upper surface of the SiGe layer 16.

When the SiGe growth reaches the top of the oxide layer 11, it overgrows laterally onto the oxide layer 11 as a single crystal, as shown in Figure 3. This process is known as epitaxial lateral overgrowth (ELO) and is used to fill each depression 14 in the oxide layer 11 close to the window 13. Because of the mechanics of the dislocations 17 that have formed in the window 13 to relieve the strain in the SiGe layer 16, substantially no dislocations are formed in the ELO filled depressions 14. This is because the dislocations 17 are only produced at the interface of a mismatched layer, that is in this case at the interface between the substrate 10 and the SiGe layer 16, which only occurs in the window 13. Since the dislocations 17 are confined to their glide planes which are at an angle to the Si surface 15, all the dislocations 17 rise from the oxide window 13 at an angle. The dislocations 17 cannot reach parts of the crystal away from the window 13, and, since there is no lattice mismatch, no further dislocations will form in the depressions 14 leaving SiGe crystal material substantially free from defects within the depressions 14.

If required the relaxation of the SiGe layer may be assisted by an annealing step carried out at an elevated temperature in the range from room temperature to 1500°C, and preferably in the range from 500 to 1,200°C, possibly with epitaxial growth of SiGe material continuing after this annealing step at a temperature in the range from room temperature to 1200°C, and preferably in the range from 350 to 900°C, to form a further SiGe layer continuous with the first SiGe layer until lateral overgrowth of the SiGe material onto the top of the oxide layer 11 occurs.

After filling of the depressions 14 with SiGe the surface of the wafer is polished flat down to the level of the oxide layer 11 in order to remove those parts of the SiGe layer 16 that have overgrown the oxide layer 11, thereby leaving substantially dislocation-free virtual substrates 18 of Si Ge completely isolated from the underlying substrate 10 and from the SiGe within the window 13 by the surrounding oxide, as shown in Figure 4.

Referring to Figure 5, it is possible in a further optional step to etch all the oxide and epitaxy away except for the virtual substrate 18 on the underlying oxide. This can be done by a selective etching step after the area to be etched has been defined, for example by the application of a photoresist layer and the selective exposure and development of the photoresist layer to form a photoresist mask. This would then be an ideal template for strained silicon devices which could be integrated with "normal" silicon devices on the silicon substrate. The virtual substrate need only be fabricated underneath the devices which need the performance enhancements of strained silicon. In this case the oxide underneath the virtual substrates would need to be thin in order that the surface is kept as planar as possible for device processing.

In this manner a high quality virtual substrate is produced which may be used for the growth of strained Si or SiGe active layers and unstrained III-V semiconductor active layers within which active semiconductor devices may be fabricated.

The Ge composition within the SiGe material may be substantially constant through the thickness of the SiGe layer 16, although it would also be possible for the Ge composition to be graded so that it increases from a first composition at a lower level in the layer to a second, higher composition at a higher level in the layer.

Various modifications of the above-described method are possible within the scope of the invention. For example, instead of the depressions being separated from the window by intervening parts of the isolating layer, the depressions could be formed by stepped edges at the sides of the window, so that the lateral overgrowth of the SiGe layer onto the step forms the virtual substrate. This essentially amounts to the depressions overlapping the window, and prevent the need for the overgrowth to grow down into the depressions.

Furthermore a similar method may be used for growth of any appropriate semiconductor material other than SiGe on to a substrate with which it has a lattice mismatch. The same dislocation dynamics would apply as described above in the production of a substantially defect-free virtual substrate of such other materials. Examples of suitable other materials that could be grown in this manner include SiC, SiGeC, InP and GaAs. In the case of the growth of GaAs onto silicon, which is advantageous in the field of optoelectronics, the GaAs is grown directly on the Si substrate without the need for a separate virtual substrate.

This fabrication technique may be used to produce a virtual substrate in only one or more selected areas of the chip (as may be required for system-on-a-chip integration) in which enhanced circuit functionality is required, for example.

The method of the invention is capable of a wide range of applications, including the provision of a virtual substrate for the growth of strained or relaxed Si, Ge or SiGe layers for fabrication of devices such as bipolar junction transistors (BJT), field effect transistors (FET) and resonance tunnelling diodes (RTD), as well as III-V semiconductor layers for high speed digital interface to CMOS technologies and optoelectronic applications including light emitting diodes (LEDs) and semiconductor lasers.

## Claims

1. A method of forming a lattice-tuning semiconductor substrate, comprising:
(a) defining a selected area (12) of a semiconductor surface (15) by means of a window (13) extending through an isolating layer (11) on the semiconductor surface (15);
(b) defining in the vicinity of the window (13) a depression (14) in the isolating layer (11);
(c) growing on top of the selected area (12) of the semiconductor surface (15) an active layer (16) of a semiconducting material that is not lattice-matched to the material of the semiconductor surface (15) such that dislocations (17) are formed in the window (13) to relieve the strain in the active layer (16); and
(d) further growing the active layer (16) to overgrow the isolating layer (11) and fill the depression (14) to form a dislocation-free area (18) of said semiconducting material within the depression (14).

2. A method according to claim 1, wherein, after the growing of the active layer (16) to fill the depression (14), the portion of the active layer (16) that has overgrown the isolating layer (11) is removed so as to isolate the dislocation-free area (18) of said semiconducting material within the depression (14) from the area of said semiconducting material within the window (13).

3. A method according to claim 2, wherein the portion of the active layer (16) that has overgrown the isolating layer (11) is removed by polishing down to the level of the isolating layer (11).

4. A method according to claim 1, 2 or 3, wherein, after the growing of the active layer (16) to fill the depression (14), the active layer (16) and the isolating layer (11) are removed from the semiconductor surface (15) except in the vicinity of the depression (14) so as to leave on the semiconductor surface (15) the dislocation-free area (18) of said semiconducting material isolated from the semiconductor surface (15) by the portion of the isolating layer (11).

5. A method according to claim 4, wherein the active layer (16) and the isolating layer (11) are removed from the semiconductor surface (15) by etching.

6. A method according to any preceding claim, wherein the active layer (16) is annealed at an elevated temperature in order to fully relieve the strain in the active layer (16).

7. A method according to claim 6, wherein the growth of the active layer (16) is carried out at a temperature in the range from room temperature to 1200°C, and the annealing of the active layer (16) is carried out at an elevated temperature in the range from room temperature to 1500°C.

8. A method according to any preceding claim, wherein the semiconductor surface is a Si surface, and the semiconducting material of the active layer (16) is SiGe.

9. A method according to claim 8, wherein the active layer (16) has a Ge composition ratio that is constant within the SiGe layer (16).

10. A method according to claim 8, wherein the active layer (16) comprises first and second sub-layers, one of the sub-layers having a Ge composition ratio that is constant within the sub-layer, and the other sub-layer having a Ge composition ratio that increases within the layer from a first level to a second level greater than the first level.

11. A method according to claim 10, wherein intermediate processing is conducted between the growth of the first and second sub-layers.

12. A method according to claim 11, wherein the intermediate processing incorporates a step of annealing the first sub-layer at an elevated temperature in order to fully relieve the strain in the first sub-layer.

13. A method according to claim 11 or 12, wherein the intermediate processing step incorporates a chemo-mechanical polishing step.

14. A method according to any preceding claim, wherein the active layer (16) is grown by a selective epitaxial growth process.

15. A method according to claim 14, wherein the epitaxial growth process is chemical vapour deposition (CVD).

16. A method according to any preceding claim, further comprising the step of growing on top of the active layer (16) a strained Si layer within which one or more semiconductor devices are formed.

17. A method according to any preceding claim, wherein the isolating layer (11) is a Si oxide layer grown on the semiconductor surface (15).

## Patentansprüche

1. Verfahren zum Bilden eines Gitterabstimmmungs-Halbleitersubstrats, umfassend:
(a) das Definieren eines ausgewählten Bereichs (12) einer Halbleiterobefläche (15) durch ein Fenster (13), das sich durch eine Isolierschicht (11) auf der Halbleiteroberfläche (15) erstreckt;
(b) das Definieren in der Nähe des Fensters (13) einer Vertiefung (14) in der Isolierschicht (11);
(c) das Wachsenlassen oben auf dem ausgewählten Bereich (12) der Halbleiteroberfläche (15) einer aktiven Schicht (16) eines Halbleitermaterials, das nicht an dass Material der Halbleiteroberfläche (15) gitterangepasst ist, derart, dass Verschiebungen (17) in dem Fenster (13) gebildet werden, um die Spannungsbeanspruchung in der aktiven Schicht (16) zu entlasten; und
(d) das weitere Wachsenlassen der aktiven Schicht (16), um die Isolierschicht (11) zu Überwachsen und die Vertiefung (14) zu füllen, um einen verschiebungsfreien Bereich (18) des Halbleitermaterials innerhalb der Vertiefung (14) zu bilden.

2. Verfahren nach Anspruch 1, wobei nach dem Wachsenlassen der aktiven Schicht (16), um die Vertiefung (14) zu füllen, der Anteil der aktiven Schicht (16), der über die Isolierschicht (11) gewachsen ist, entfernt wird, um den verschiebungsfreien Bereich (18) des Halbleitermaterials innerhalb der Vertiefung (14) von dem Bereich des Halbleitermaterials innerhalb des Fensters (13) zu isolieren.

3. Verfahren nach Anspruch 2, wobei der Anteil der aktiven Schicht (16), der über die Isolierschicht (11) gewachsen ist, durch Abschleifen bis auf das Niveau der Isolierschicht (11) herunter entfernt wird.

4. Verfahren nach Anspruch 1, 2 oder 3, wobei nach dem Wachselassen der aktiven Schicht (16), um die Vertiefung (14) zu füllen, die aktive Schicht (16) und die Isolierschicht (11) von der Halbleiteroberfläche (15), in der Nähe der Vertiefung (14) ausgenommen, entfernt werden, um auf der Halbleiteroberfläche (15) den verschiebungsfreien Bereich (18) des Halbleitermaterials von der Halbleiteroberfläche (15) durch den Anteil der Isolierschicht (11) isoliert zu lassen.

5. Verfahren nach Anspruch 4, wobei die aktive Schicht (16) und die Isolierschicht (11) durch Ätzen von der Halbleiteroberfläche (15) entfernt werden.

6. Verfahren nach einem der vorhergehenden Ansprüche, wobei die aktive Schicht (16) bei einer erhöhten Temperatur getempert wird, um die Spannungsbeanspruchung in der aktiven Schicht (16) zu entlasten.

7. Verfahren nach Anspruch 6, wobei das Wachsenlassen der aktiven Schicht (16) bei einer Temperatur im Bereich von der Raumtemperatur bis 1200 °C und das Tempern der aktiven Schicht (16) bei einer erhöhten Temperatur im Bereich von der Raumtemperatur bis 1500 °C durchgeführt wird.

8. Verfahren nach einem der vorhergehenden Ansprüche, wobei die Halbleiteroberfläche eine Si-Fläche ist und das Halbleitermaterial der aktiven Schicht (16) SiGe ist.

9. Verfahren nach Anspruch 8, wobei die aktive Schicht (16) ein Ge-Zusammensetzungsverhältnis aufweist, das innerhalb der SiGe-Schicht (16) konstant ist.

10. Verfahren nach Anspruch 8, wobei die aktive Schicht (16) erste und zweite Unterschichten umfasst, wobei eine der Unterschichten ein Ge-Zusammensetzungsverhältnis aufweist, das innerhalb der Unterschicht konstant ist, und die andere Unterschicht ein Ge-Zusammensetzungsverhältnis aufweist, das innerhalb der Schicht von einem ersten Niveau auf ein zweites Niveau, das höher als das erste Niveau ist, steigt.

11. Verfahren nach Anspruch 10, wobei das Zwischenverarbeiten zwischen dem Wachsen der ersten und zweiten Unterschichten durchgeführt wird.

12. Verfahren nach Anspruch 11, wobei das Zwischenverarbeiten einen Schritt des Temperns der ersten Unterschicht bei einer erhöhten Temperatur umfasst, um die Spannungsbeanspruchung in der ersten Unterschicht vollständig zu entlasten.

13. Verfahren nach Anspruch 11 oder 12, wobei das Zwischenverarbeiten einen chemisch-mechanischen Abschleifschritt umfasst.

14. Verfahren nach einem der vorhergehenden Ansprüche, wobei die aktive Schicht (16) durch ein selektives epitaxiales Wachstumsverfahren wachsen gelassen wird.

15. Verfahren nach Anspruch 14, wobei das epitaxiale Wachstumsverfahren die chemische Gasphasenabscheidung (CVD) ist.

16. Verfahren nach einem der vorhergehenden Ansprüche, des Weiteren den Schritt des Wachsenlassens oben auf der aktiven Schicht (16) einer spannungsbeanspruchten Si-Schicht, innerhalb der ein oder mehrere Halbleitervorrichtungen gebildet sind, umfasst.

17. Verfahren nach einem der vorhergehenden Ansprüche, wobei die Isolierschicht (11) eine Si-Oxidschicht ist, die auf der Halbleiteroberfläche (15) wachsengelassen wird.

## Revendications

1. Procédé de formation d'un substrat semi-conducteur accordé au réseau, comprenant:
(a) la définition d'une zone choisie (12) de la surface d'un semi-conducteur (15) au moyen d'une fenêtre (13) s'étendant à travers une couche isolante (11) sur la surface du semi-conducteur (15);
(b) la définition, dans le voisinage de la fenêtre (13), d'un creux (14) dans la couche isolante (11);
(c) la croissance, sur le dessus de la zone choisie (12) de la surface du semi-conducteur (15), d'une couche active (16) d'un matériau semi-conducteur qui n'est pas apparié au réseau avec le matériau de la surface du semi-conducteur (15) de sorte que des dislocations (17) sont formée dans la fenêtre (13) pour soulager la contrainte dans la couche active (16); et
(d) la croissance supplémentaire de la couche active (16) pour qu'elle recouvre la couche isolante (11) et remplisse le creux (14) pour former une zone exempte de dislocation (18) dudit matériau semi-conducteur à l'intérieur du creux (14).

2. Procédé selon la revendication 1, dans lequel, après la croissance de la couche active (16) pour remplir le creux (14), la partie de la couche active (16) qui recouvre la couche isolante (11) est enlevée de façon à isoler la zone exempte de dislocation (18) dudit matériau semi-conducteur à l'intérieur du creux (14) de la zone dudit matériau semi-conducteur à l'intérieur de la fenêtre (13).

3. Procédé selon la revendication 2, dans lequel la partie de la couche active (16) qui recouvre la couche isolante (11) est enlevée en polissant jusqu'au niveau de la couche isolante (11).

4. Matériau selon la revendication 1, 2 ou 3, dans lequel, après la croissance de la couche active (16) pour remplir le creux (14), la couche active (16) et la couche isolante (11) sont enlevées de la surface du semi-conducteur (15) sauf au voisinage du creux (14) de façon à laisser sur la surface du semi-conducteur (15) la zone exempte de dislocation (18) dudit matériau semi-conducteur isolée de la surface du semi-conducteur (15) par la partie de la couche isolante (11).

5. Procédé selon la revendication 4, dans lequel la couche active (16) et la couche isolante (11) sont enlevées de la surface du semi-conducteur (15) par attaque.

6. Procédé selon l'une quelconque des revendications précédentes, dans lequel la couche active (16) est recuite à une température élevée afin de soulager totalement la contrainte dans la couche active (16).

7. Procédé selon la revendication 6, dans lequel la croissance de la couche active (16) est effectuée à une température dans la gamme de la température ambiante à 1200°C, et le recuit de la couche active (16) est effectué à une température élevée dans la gamme de la température ambiante à 1500°C.

8. Procédé selon l'une quelconque des revendications précédentes, dans lequel la surface du semi-conducteur est une surface de Si, et le matériau semi-conducteur de la couche active (16) est SiGe.

9. Procédé selon la revendication 8, dans lequel la couche active (16) a un rapport de composition de Ge qui est constant à l'intérieur de la couche de SiGe (16).

10. Procédé selon la revendication 8, dans lequel la couche active (16) comprend des première et seconde sous-couches, l'une des sous-couches ayant un rapport de composition de Ge qui est constant à l'intérieur de la sous-couche, et l'autre sous-couche ayant un rapport de composition de Ge qui augmente à l'intérieur de la couche à partir d'un premier niveau jusqu'à un second niveau plus grand que le premier niveau.

11. Procédé selon la revendication 10, dans lequel le traitement intermédiaire est effectué entre la croissance des première et seconde sous-couches.

12. Procédé selon la revendication 11, dans lequel le traitement intermédiaire incorpore une étape consistant à recuire la première sous-couche à une température élevée afin de soulager totalement la contrainte dans la première sous-couche.

13. Procédé selon la revendication 11 ou 12, dans lequel l'étape de traitement intermédiaire incorpore une étape de polissage chimio-mécanique.

14. Procédé selon l'une quelconque des revendications précédentes, dans lequel la couche active (16) est développée par un procédé de croissance épitaxiale sélective.

15. Procédé selon la revendication 14, dans lequel le procédé de croissance épitaxiale est le dépôt chimique en phase vapeur (CVD).

16. Procédé selon l'une quelconque des revendications précédentes, comprenant en outre l'étape consistant à développer, sur le dessus de la couche active (16), une couche de Si contrainte à l'intérieur de laquelle un ou plusieurs dispositifs à semi-conducteur sont formés.

17. Procédé selon l'une quelconque des revendications précédentes, dans lequel la couche isolante (11) est une couche d'oxyde de Si développée sur la surface du semi-conducteur (15).
